Europäisches Patentamt

European Patent Office

Office européen des brevets

(11) Publication number: 0 390 502
A2

# (12) EUROPEAN PATENT APPLICATION

(21) Application number: 90303259.7

(51) Int. Cl.5: C30B 15/02, C30B 29/06

(22) Date of filing: 27.03.90

(30) Priority: 26.07.89 JP 193715/89
30.03.89 JP 76697/89

(43) Date of publication of application:
03.10.90 Bulletin 90/40

(84) Designated Contracting States:
DE FR GB IT NL

(71) Applicant: NKK CORPORATION
1-2 Marunouchi 1-chome, Chiyoda-ku
Tokyo(JP)

(72) Inventor: Mohri, Yoshio, c/o NKK
CORPORATION
1-2 Marunouchi 1-chome, Chiyoda-ku
Tokyo(JP)
Inventor: Araki, Kenji, c/o NKK CORPORATION
1-2 Marunouchi 1-chome, Chiyoda-ku
Tokyo(JP)
Inventor: Kuroda, Koichi, c/o NKK
CORPORATION
1-2 Marunouchi 1-chome, Chiyoda-ku
Tokyo(JP)

(74) Representative: Marsh, Roy David et al
Urquhart-Dykes & Lord 419B Midsummer
House Midsummer Boulevard
Central Milton Keynes MK9 3BN(GB)

(54) Apparatus for manufacturing silicon single crystals.

(57) A Chochralski method-type silicon single crystal
manufacturing apparatus including a feeding device
for continuously feeding granular silicon starting ma-
terial into a crucible. The apparatus comprises a
silicon single crystal manufacturing apparatus having
a continuous granular silicon starting material feed-
ing device including a housing (11) containing a
reduced-pressure inert gas atmosphere, a rotating
cylinder (14) arranged inside the housing (11) and
having a plurality of granule catch portions (15) on
its outer peripheral surface and a storage hopper
(12) arranged above the rotating cylinder (14). The
feeding device is so arranged that the distance (gap)
between the lower discharge port end (13) of the
storage hopper (12) and the outer peripheral surface
is greater than the maximum diameter of the granu-
lar silicon and the distance (gap) has the maximum
value sufficient to cause the granular silicon to accu-
mulate with an angle of repose at the distance (gap).
The granule catch portions (15) on the outer periph-
eral surface of the rotating cylinder (14) take the
form of any of various kinds of projections or
grooves.

Fig.1

## APPARATUS FOR MANUFACTURING SILICON SINGLE CRYSTALS

### BACKGROUND OF THE INVENTION

#### Field of the Invention

The present invention relates to a silicon single crystal manufacturing apparatus equipped with a feeding device for continuously feeding granular silicon starting material into a crucible.

#### Description of the prior Art

Apparatus heretofore known for the manufacture of silicon single crystals by the Chochralski method include apparatus of the type which continuously pulls a silicon single crystal while feeding granular starting material into a crucible. In this case, generally the use of a vibrating feeder as a starting material feeder tends to be conceived due to it being simple in construction. The vibrating feeder is such that starting material granules are fed onto a vibrating plate and the vibrating plate is vibrated to feed the starting material granules. With this method, the feed rate is controlled by controlling the vibrational amplitude or the number of vibrations of the vibrating plate. Japanese Laid-Open Patent No. 61-17537 proposes a type of vibrating feeder.

With this vibrating feeder, the feed rate of starting material is considerably affected by the size of the starting material. In other words, the feed rate is increased with increase in the size of the granules and the feed rate is decreased with decrease in the particle size. The particle size of silicon granules varies considerably and its distribution range is from about 0.1mmø to about 5mmø.

In addition, it is difficult to completely mix these granules. Therefore, the segregation of the large granules only or the segregation of the small granules only is unavoidable. Thus, in the case of the vibrating feeder variation in the feed rate due to the segregation of the starting material granules is unavoidable. This variation is undesirable from the single crystal growing point of view since it varies the heat environment of the single crystal growing crucible.

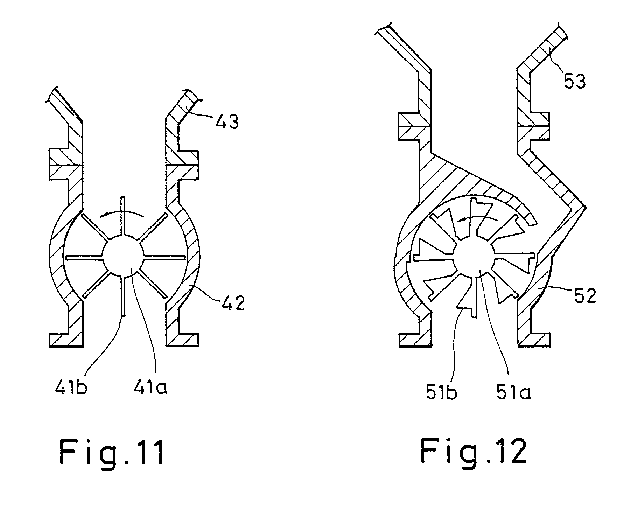

A rotary valve is another type of feeding device which is conceivable. Fig. 11 is a sectional view of the rotary valve. Numeral 41 designates a rotor, 41a a shaft and 41b blades. Numeral 42 designates a case, and 43 a granule storage hopper. With this rotary valve, the rotor 41 having a plurality of the blades 41b attached to the shaft 41a is rotated within the case 42. The granules discharged from the upward granule storage hopper 43 are taken into the spaces between the blades 41b and the case 42 and they are successively discharged from the lower part of the case 42.

On the other hand, the granules tend to be jammed between the blades of the rotor and the case in the rotary valve. When this occurs, the rotor is no longer rotated.

Also, the granules rub on the inner surface of the case as the granules are moved within the case by the rotation of the rotor. As a result, the inner surface of the case is worn out. The worn-out case inner surface results in an impurity in a silicon crystal. Due to these two problems, the rotary valve is not preferred for use as a starting material feeding method.

### SUMMARY OF THE INVENTION

It is an object of the present invention to provide a granular silicon feeding device used with silicon single crystal manufacturing apparatus of the continuous feeding Chochralski method type which grows a single crystal while feeding silicon starting material granules into a crucible.

To accomplish the above object, in accordance with the present invention there is thus provided a granular silicon feeding device including a rotating cylinder formed with a plurality of projection or grooves on its outer peripheral surface and having a horizontal rotary shaft, a silicon granule storage hopper arranged above the rotating cylinder, and a housing adapted to contain the rotating cylinder and the storage hopper and to replace the air with inert gas atmosphere, whereby the distance between the discharge port lower end of the storage hopper and the outer peripheral surface of the rotating cylinder is selected so that the distance is greater than the maximum particle diameter of the silicon granules and that the silicon granules discharged form the lower discharge port of the hopper are accumulated on the upper side of the rotating cylinder forming an angle of repose upon the stopping of the rotation of the rotating cylinder, thereby stopping the feeding of the granules.

The granular silicon starting material discharged from the lower discharge port of the storage hopper is first caused to fall on the outer peripheral surface of the rotating cylinder. Since the plurality of projections or grooves are formed on the outer peripheral surface, the granular silicon starting material does not fall off but stays on the outer peripheral surface. The material falls downward only in response to the rotation of the rotating cylinder. The fallen material is fed to the crucible. The feed rate of the silicon starting material is controlled in according with the rotation speed of the rotating cylinder.

Also when the rotation of the cylinder is stopped, the granular silicon starting material discharged from the lower discharge port of the storage hopper is accumulated on the outer peripheral surface of the cylinder due to the angle of repose of the granules. In other words, the feeding of the material into the crucible is stopped. If the distance between the discharge port lower end of the storage hopper and the outer peripheral surface of the rotating cylinder is excessively large, no angle of repose is formed and therefore the discharge of the silicon granules cannot be stopped upon the stopping of the rotating cylinder. On the contrary, if the distance is less than the maximum diameter of the silicon granules, the silicon granules are jammed between the cylinder and the discharge port lower end thus preventing the cylinder from rotating.

The factors affecting the feed rate of the silicon granules are the distance between the discharge port in the lower end of the storage hopper and the outer peripheral surface of the rotating cylinder and the rotation speed of the cylinder. The feed rate is practically not subjected to the effect of the starting material particle size. Thus, in operation the feed rate of the silicon granules is controlled by controlling the rotation speed of the cylinder.

BRIEF DESCRIPTION OF THE DRAWINGS

Fig. 1 is a longitudinal sectional view of a silicon starting material feeding device according to an embodiment of the present invention.

Fig. 2 is a schematic view of gear tooth-like projections showing an example of the projections formed on the outer peripheral surface of the rotating cylinder in the embodiment of the present invention.

Fig. 3 is a schematic diagram showing the condition in which the silicon granules stay with an angle of repose between the rotating cylinder formed with the projections of Fig. 2 and the discharge port in the lower part of the storage hopper.

Fig. 4 is a sectional view of a starting material feeding device according to another embodiment of the present invention, in which bilge-like grooves are formed on the outer peripheral surface of a rotating cylinder.

Fig. 5 is a schematic diagram showing an example of the projections formed on the outer peripheral portion of the rotating cylinder in the embodiment of the invention, with the projections being in the form of parallel plate-like projections.

Fig. 6 is a schematic diagram showing an example of the projections formed on the outer peripheral portion of the rotating cylinder in the embodiment of the invention, with the projections being in the form of cylindrical bar- shaped projections.

Fig. 7 is a schematic diagram showing an example of the grooves formed in the outer peripheral portion of the rotating in the embodiment of the invention, with the grooves being in the form of parallel furrow-type grooves.

Fig. 8 is a schematic diagram showing a modification of the grooves of Fig. 7 which are formed in the form of a network.

Fig. 9 is a schematic diagram showing an example of the grooves in the form of pit-like grooves.

Fig. 10 is a schematic diagram showing the combined use of the cylindrical bar-shaped projections of Fig. 6 and the pit-like grooves of Fig. 9.

Fig. 11 is a longitudinal sectional view showing an example of the conventional rotary valve.

Fig. 12 is a longitudinal rotary valve showing another example of the conventional rotary valve.

DESCRIPTION OF THE PREFERRED EMBODIMENTS

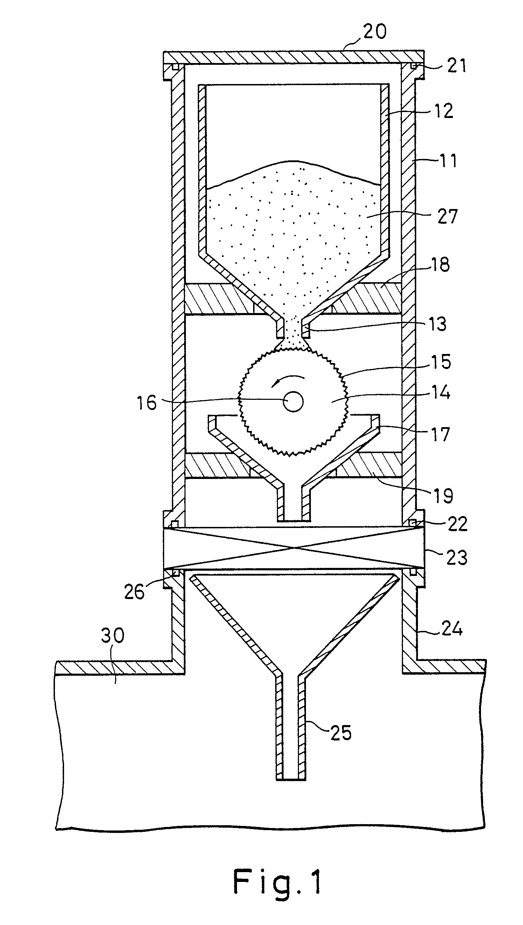

Embodiments of the present invention will now be described in greater detail with reference to the accompanying drawings. Fig. 1 is a longitudinal sectional view of a silicon starting material feeding device according to an embodiment of the present invention. Arranged above an opening 24 of a chamber 30 in a silicon single crystal manufacturing apparatus is a housing 11 which is communicated with the chamber 30 through a sluice valve 23. An inside of the housing 11 is filled with inert gas as in the case of the silicon single crystal pull chamber. Arranged on the top of the housing 11 is a detachable cover 20 for permitting the replenishment of silicon granules 27. The detachable cover 20 is bolted to the housing 11 through an O-ring 21.

Arranged inside the housing 11 are a storage hopper 12 for storing the silicon granules 27 and discharging them from the discharge port in the lower part thereof, a hopper support 18 for holding the storage hopper 12, a rotating cylinder 14 having a horizontal rotary shaft 16. a first funnel-shaped guide pipe 17 and a guide pipe support 19. Arranged in the opening 24 of the chamber 30 is a second funnel-shaped guide pipe 25 for directing the silicon granules to a crucible.

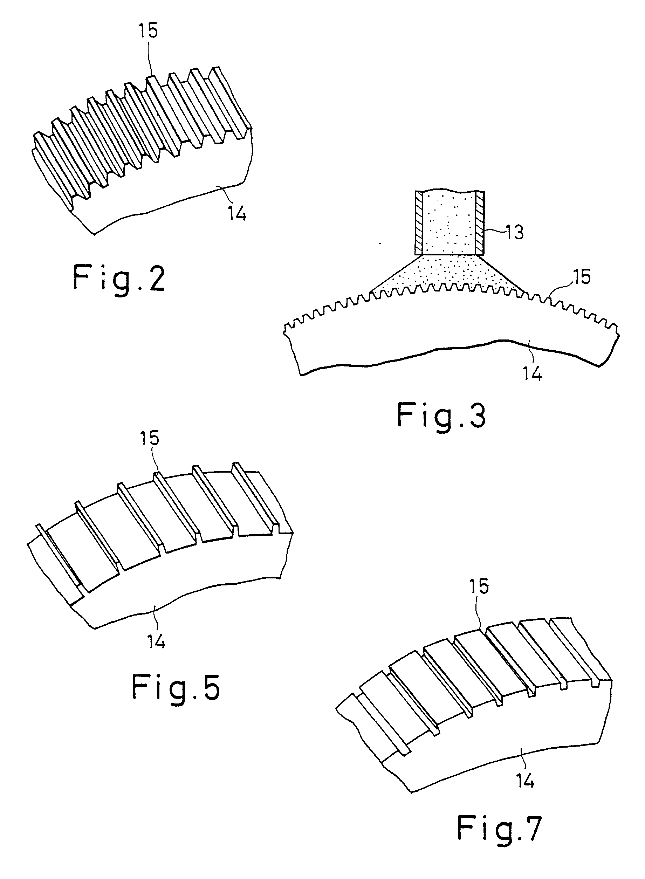

A plurality of projections or grooves 15 are formed on the outer peripheral surface of the rotating cylinder 14 so as to prevent the silicon granules 27 from falling off. Figs. 2 and 3 and Figs. 5 to 10 are schematic or sectional views each showing an example of the projections or grooves 15.

Fig. 2 is a schematic diagram showing the projections 15 in the form of gear tooth-like projections. and Fig. 3 is a longitudinal sectional view showing the rotating cylinder 14 formed with the projections of Fig. 2 and a discharge port 13 in the hopper lower part.

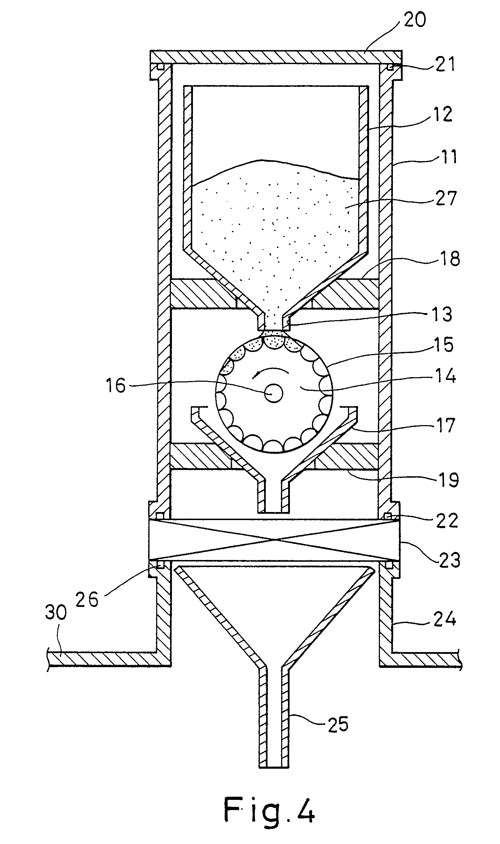

Fig. 4 is a sectional view of the starting material feeding device in which the outer peripheral surface of the rotating cylinder is formed with bilge-like grooves and in this case the outer peripheral shape of the rotating cylinder 14 can be easily produced.

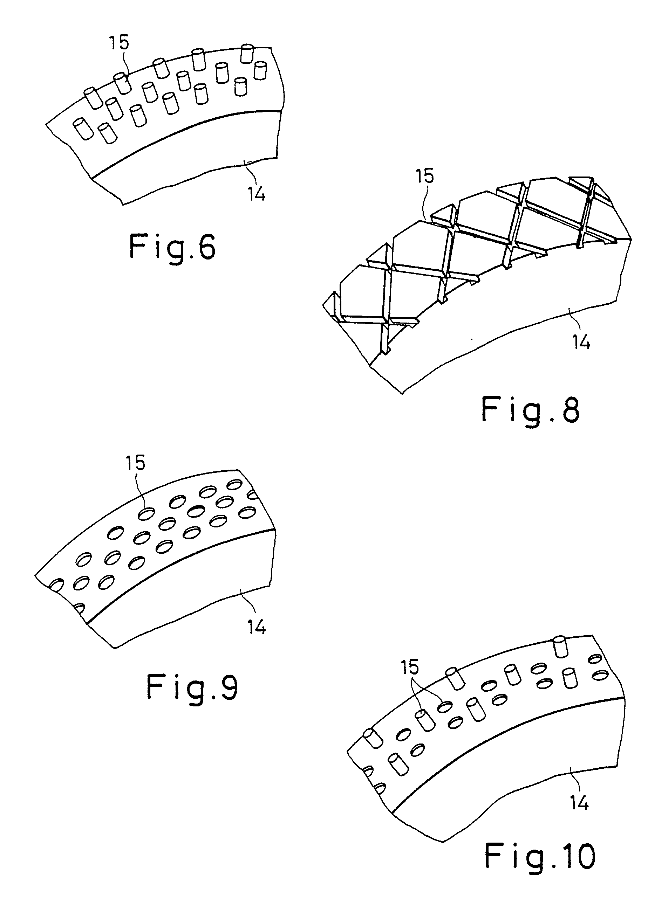

Figs. 5 and 6 show cases where the outer peripheral portion of the rotating cylinder 14 is formed with a plurality of plate-type projections which are parallel to each other or a plurality of cylindrical bar-shaped projections which are arranged in a suitable distribution.

Fig. 7, 8 and 9 show examples of the grooves formed in the outer peripheral surface of the rotating cylinder so as to catch the silicon granules, with Fig. 7 showing furrow-shaped grooves which are parallel to each other,

Fig. 8 grooves arranged in a network and Fig. 9 pit-like grooves distributed suitably.

Fig. 10 shows a case in which cylindrical projections and pit-like grooves are arranged in combination.

With the construction described above, the embodiment of the present invention operates as follows. The silicon granules 27 loaded into the storage hopper 12 are continuously discharged from the lower discharge port 13 of the storage hopper 12 so that the silicon granules 27 are fed onto the outer peripheral surface of the rotating cylinder 14 arranged just below the discharge port 13. The silicon granules fed are prevented from falling off owing to the plurality of projections formed in the outer peripheral surface of the rotating cylinder 14 and thus they stay on the outer peripheral portion of the rotating cylinder 14. Then, the silicon granules are moved by the rotation of the rotating cylinder 14 so that they are caused to successively fall off the outer peripheral portion by the force of gravity. The silicon granules fallen are fed into the crucible through the first and second funnel-shaped guide pipes.

The feed rate of the silicon granules 27 is determined by the distance between the lower end of the lower discharge port 13 of the storage hopper 12 and the outer peripheral surface of the rotating cylinder 14 and the rotation speed of the rotating cylinder 14. From the practical point of view, the feed rate of the silicon granules is controlled by controlling the rotation speed of the rotating cylinder 14.

When the rotation of the rotating cylinder 14 is stopped, the silicon granules are accumulated on the upper part of the rotating cylinder 14 with a given angle of repose. At this time, the movement of the silicon granules is stopped and the feeding of the silicon granules to the crucible is stopped.

With the granular silicon feeding device according to the present embodiment, the feed rate is not subject to the sizes of the starting material as in the case of the conventional vibrating feeder and it is possible to stably produce single crystals which are excellent in quality.

Also, due to the absence of any case which faces the outer peripheral surface of the rotating cylinder as in the case of the rotary valve, there is no problem of the silicon granules being jammed between the inner peripheral surface of the case and the outer peripheral surface of the rotating cylinder thus stopping the rotation of the rotating cylinder.

In addition, there is no problem of producing an impurity due to the wearing out of the case.

Further, in the starting material feeding device of the present embodiment, those portions of the storage hopper 12, the rotating cylinder 14, the funnel-shaped guide pipes 17 and 25, etc., which contact with the silicon granules are made of such material as silica, silicon or teflon, and this has the effect of completely preventing the entry of any impurity into the crucible.

In accordance with the granular silicon feeding device of the present invention, the feed rate of starting material is stabilized and also there is no problem of the material being contaminated. Therefore, the starting material continuous feed-type Chochralski method is made possible thereby making possible the manufacture of high-quality silicon single crystals.

## Claims

1. In a continuous-feed Chochralski method-type single crystal manufacturing apparatus including a silicon feeding device for continuously feeding granular silicon starting material into a crucible, the improvement comprising:

a housing containing a reduced-pressure inert gas atmosphere;

a rotating cylinder arranged inside said housing and mounted on a horizontal rotary shaft, said rotating cylinder being formed with a plurality of granule catch portions on an outer peripheral surface thereof; and

a storage hopper arranged above said rotating cylinder such a manner that a distance between a discharge port lower end of said storage hopper and the outer peripheral surface of said rotating cylinder is in a range between a minimum value greater than a maximum diameter of said silicon granules and a maximum value constituting a limit value such that upon stopping the rotation of said rotating cylinder said silicon granules discharged from said discharged port are accumulated with an angle of repose on the outer peripheral surface of said rotating cylinder.

2. A silicon single crystal manufacturing apparatus according to claim 1, wherein said plurality of granule catch portions arranged on the outer peripheral surface of said rotating cylinder comprise a plurality of projections.

3. A silicon single crystal manufacturing apparatus according to claim 1, wherein said plurality of granule catch portions arranged on the outer peripheral surface of said rotating cylinder comprise a plurality of grooves.

4. A silicon single crystal manufacturing apparatus according to claim 1, wherein said plurality of granule catch portions arranged on the outer peripheral surface of said rotating cylinder comprise a combination of a plurality of projections and a plurality of grooves.

5. A silicon single crystal manufacturing apparatus according to claim 2, wherein said projections comprise gear tooth-like projections.

6. A silicon single crystal manufacturing apparatus according to claim 2, wherein said projections comprise a plurality of plate-type projections arranged parallel to said rotary shaft.

7. A silicon single crystal manufacturing apparatus according to claim 2, wherein said projections comprise a plurality of bar-shaped projections arranged independently of one another.

8. A silicon single crystal manufacturing apparatus according to claim 3, wherein said grooves comprise a plurality of furrow-like grooves.

9. A silicon single crystal manufacturing apparatus according to claim 3, wherein said grooves comprise a plurality of net-like grooves.

10. A silicon single crystal manufacturing apparatus according to claim 3, wherein said grooves comprise a plurality of pit-like grooves.

11. A silicon single crystal manufacturing apparatus according to claim 4, wherein said plurality of granule catch portions arranged on the outer peripheral surface of said rotating cylinder comprise a plurality of bar-shaped projections and a plurality of pit-like grooves.

12. A silicon single crystal manufacturing apparatus according to claim 1, wherein at least portions of said storage hopper and said rotating cylinder which contact with said granular silicon are made from silica, silicon or teflon.

13. A silicon single crystal manufacturing apparatus according to claim 3, wherein said grooves comprise a plurality of bilge-type grooves.

14. A silicon single crystal manufacturing apparatus according to claim 1, wherein the rate of feed of said silicon starting material is controlled by controlling a rotation speed of said rotating cylinder.

Fig.1

Fig.2

Fig.3

Fig.5

Fig.7

Fig.4

Fig.6

Fig.8

Fig.9

Fig.10

Fig.11

Fig.12